# EUROPEAN PATENT SPECIFICATION

(11) **EP 1 714 323 B1**
(45) Date of publication and mention of the grant of the patent: **21.11.2018**
(21) Application number: 05708314.9
(22) Date of filing: 14.02.2005
(51) Int. Cl.: H01L 29/165, H01L 21/20

(54) **COMPOUND SEMICONDUCTOR DEVICE AND METHOD OF PRODUCING THE SAME**
VERBUND-HALBLEITERBAUELEMENT UND HERSTELLUNGSVERFAHREN DAFÜR
DISPOSITIF SEMI-CONDUCTEUR COMPOSE ET PROCEDE DE PRODUCTION DE CELUI-CI

(30) Priority: 13.02.2004 GB 0403190
(43) Date of publication of application: 25.10.2006
(73) Proprietor: IQE Silicon Compounds Ltd., St. Mellons Cardiff CF2 0LW (GB)
(72) Inventor: FISHER, Maurice Howard, Cricklade, Wiltshire SN6 6BP (GB); ROUMIGUIERES, Benoit Alfred Louis, Cardiff CF23 8LA (GB); MORGAN, Aled Owen, Card iff CF5 1ET (GB)
(74) Representative: Davies, Gregory Mark
(86) International application number: PCT/GB2005/000490
(87) International publication number: WO 2005/081320

(56) References cited:
- WO-A-03/103031
- US-A1- 2002 017 642
- US-A1- 2002 125 475
- ROMANATO F ET AL: "Continuously graded buffers for InGaAs/GaAs structures grown on GaAs" JOURNAL OF CRYSTAL GROWTH, NORTH-HOLLAND, AMSTERDAM, NL, vol. 175-176, May 1997 (1997-05), pages 1009-1015, XP004091436 ISSN: 0022-0248
- PATENT ABSTRACTS OF JAPAN vol. 2003, no. 11, 5 November 2003 (2003-11-05) & JP 2003 197544 A (SUMITOMO MITSUBISHI SILICON CORP), 11 July 2003 (2003-07-11)

## Description

This invention relates to a compound semiconductor device and to a method of producing such a device.

Silicon (Si) is widely used in the manufacture of semiconductor devices, since it is readily available commercially and exhibits a number of desirable characteristics. However, with increasing demands on the speed of semiconductors, it has become desirable to form semiconductor devices from materials such as germanium (Ge), which has a larger crystalline lattice constant and which therefore can operate at higher speeds.

Unfortunately, materials such as germanium are not readily available commercially and do not possess the desirable characteristics of silicon.

In order to overcome this problem, it is well known that the electron mobility of silicon can be increased by depositing silicon onto a silicon germanium compound of say Si_{0.8}Ge_{0.2} to form a strained layer of silicon having an increased lattice constant towards that of the germanium constituent of the underlying compound.

A disadvantage of depositing a SiGe compound on a silicon semiconductor substrate is that dislocations will occur between the different materials owing their different lattice constants. In order to overcome this problem it is well known to deposit a graded compound of Si₁₋ₓGeₓ on the silicon substrate, where X is gradually varied from 0 to 0.2 over 5 to 6µm through the layer.

A disadvantage of such graded compounds is that the defectivity and surface roughness of the final compound material is poor, with the result that these undesirable characteristics are carried through to any layers deposited on the final compound material.

JP 2003197544 discloses a semi-conductor substrate provided with a Si substrate 1, a first SiGe layer 2 formed in the substrate and a second SiGe layer 3 formed on the layer 2 directly or through an Si layer. The second SiGe layer is comprised of alternately laminating inclined SiGe composition layers in each of which the percentage composition of Ge increases towards the surface interposed between fixed SiGe composition layers where a continuous percentage of composition of Ge is present.

US 2002/0017642 also discloses such alternately laminating inclined SiGe composition layers.

We have found that varying the rate of decrease of the ratio of the first material to the second material surprisingly significantly reduces the surface roughness and defectivity levels at the surface of the compound layer. The rate of decrease of the ratio increases away from the substrate towards the surface of the compound layer.

Preferably a final layer comprising said first material is deposited on the surface of the compound layer.

Preferably the first material is silicon and preferably, the second material is germanium.

Preferably the composition of the compound layer at the upper surface thereof comprises 10-50% of said second material.

Preferably the composition of the compound layer at the upper surface thereof comprises 20% of said second material.

Also in accordance with this invention, there is provided a method of manufacturing a semiconductor device, according to claim 7.

The rate of decrease of the ratio is increased from the substrate towards the surface of the compound layer.

The compound layer is grown in a chamber into which materials comprising silicon and germanium are introduced. Typically, graded compound layers are formed by varying the respective amounts of silicon and germanium materials which are introduced into the chamber. However, in the present invention, the ratio of the first material to the second material of the compound layer is preferably decreased in part by decreasing the temperature at which the layer is deposited from the substrate towards the surface of the compound layer.

An embodiment of this invention will now be described by way of examples only and with reference to the accompanying drawings, in which:
Figure 1 is a schematic sectional view through a semiconductor device:
Figure 2 is a graph showing X in Si₁₋ₓGeₓ at various points along a vertical line D extending through a graded layer of the semiconductor device Figure 1, when formed in accordance with the prior art:
Figure 3 is a similar graph of the semiconductor device of Figure 1, when formed in accordance with an embodiment of this invention; and
Figure 4 is a similar graph of the semiconductor device of Figure 1, not falling within the scope of the claims.

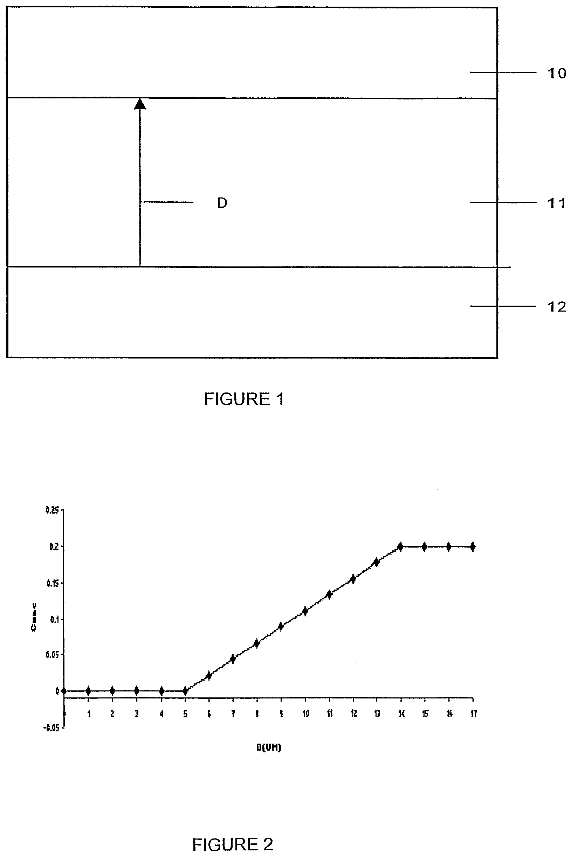

Referring to Figure 1 of the drawings, there is shown a semiconductor device comprising a silicon substrate 10, a graded compound layer 11 of Si₁₋ₓGeₓ disposed on the substrate 10 and a capping layer 12 of silicon.

Semiconductor devices of the above-mentioned construction are well known. Hitherto the graded layer 11 has been formed by increasing X in Si₁₋ₓGeₓ linearly from 0 at the surface of the substrate 10 to about 0.2 at the surface of the graded layer 11. This gradual change in X reduces crystalline dislocations of the type which would occur if Si_{0.8}Ge_{0.2} were deposited directly onto the silicon substrate 10.

The capping layer 12 of silicon adopts the larger lattice constant of the underlying Si_{0.8}Ge_{0.2} and in this manner, the silicon layer 12 has a greater electron mobility than that of a conventional silicon layer.

A disadvantage of the above-mentioned arrangement is that there is always some inherent defectivity in the graded layer 11 caused by the change in lattice constant as X increases through the layer. This also has the effect of adversely affecting the surface roughness of the layer 11. These undesirable characteristics are carried through to the silicon capping layer 12.

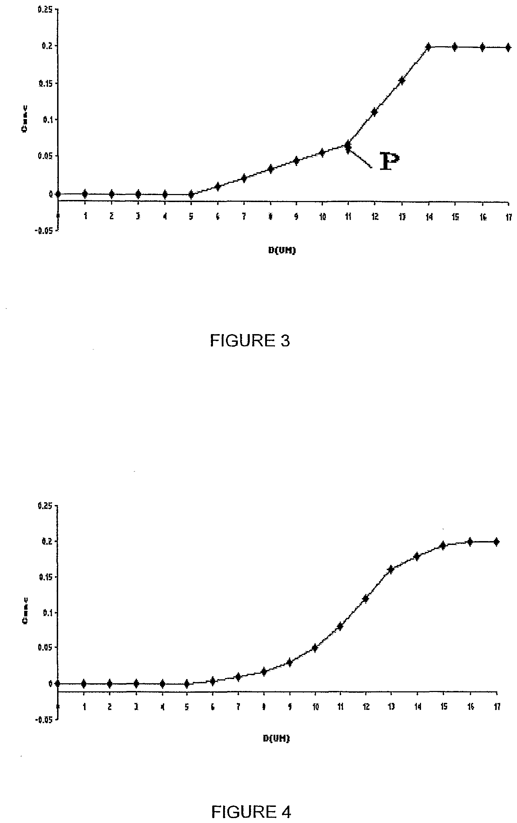

Referring to Figure 3 of the drawings, in accordance with this invention, the ratio of silicon to germanium in the graded layer 11 is gradually decreased in a linear manner until a point P is reached intermediate the layer, whereupon the linear rate of decrease of the ratio is increased until X reaches approximately 0.2.

We have found that this variation in the rate of change X through the layer 11 significantly improves the defectivity levels and the surface roughness at the surface of layer 11.

Referring to Figure 4 of the drawings, the rate of change of X may vary through the layer in a non-linear manner. However, it is preferred that the rate of change of X increases away from the surface of the substrate 10.

A graded layer in accordance with this invention can be produced by initially introducing materials comprising silicon and germanium into a chamber at a starting growth temperature. In addition to adjusting the levels of materials fed into the chamber, the temperature is decreased to partially vary the germanium content X.

## Claims

1. A semiconductor device comprising a substrate (10) of a first semiconductor material and a compound layer (11) of said first semiconductor material and a second semiconductor material disposed on the substrate, the ratio of the first material to the second material of the compound layer (11) being decreased away from the substrate towards the upper surface of the compound layer **characterised in that** there is a linear decrease of the ratio on either side of a single intermediate point and the rate of decrease of the ratio is different on either side of the intermediate point, wherein the rate of decrease of the ratio increases away from the substrate (10) towards the surface of the compound layer (11).

2. A semiconductor device as claimed in any preceding claim, in which a final layer (12) comprising said first material is deposited on the surface of the compound layer.

3. A semiconductor device as claimed in any preceding claim, in which the first material is silicon.

4. A semiconductor device as claimed in any preceding claim, in which the second material is germanium.

5. A semiconductor device as claimed in any preceding claim, in which the composition of the compound layer at the upper surface thereof comprises 10-50% of said second material.

6. A semiconductor device as claimed in claim 5, in which the composition of the compound layer at the upper surface thereof comprises 20% of said second material.

7. A method of manufacturing a semiconductor device, the method comprising providing a substrate of a first semiconductor material depositing a compound layer of said first semiconductor material and a second semiconductor material on the substrate such that the ratio of the first material to the second material of the compound layer decreases away from the substrate towards the upper surface of the compound layer, **characterised in that** there is a linear decrease of the ratio on either side of a single intermediate point and the rate of decrease of the ratio is different on either side of the intermediate point, wherein the rate of decrease of the ratio is increased away from the substrate towards the surface of the compound layer.

8. A method as claimed in claim 7, in which the ratio of the first material to the second material of the compound layer is decreased in part by decreasing the temperature at which the layer is deposited from the substrate towards the surface of the compound layer.

## Patentansprüche

1. Halbleiterbauelement, umfassend ein Substrat (10) aus einem ersten Halbleitermaterial und eine Verbundschicht (11) des ersten Halbleitermaterials und eines zweiten Halbleitermaterials, die auf dem Substrat angeordnet ist, wobei das Verhältnis des ersten Materials zu dem zweiten Material der Verbundschicht (11) weg von dem Substrat in Richtung der Oberseite der Verbundschicht abnimmt, **dadurch gekennzeichnet, dass** eine lineare Abnahme des Verhältnisses auf jeder Seite eines einzelnen Zwischenpunkts vorliegt, und dass die Abnahmerate des Verhältnisses auf jeder Seite des Zwischenpunkts unterschiedlich ist, wobei die Abnahmerate des Verhältnisses von dem Substrat (10) weg in Richtung der Oberfläche der Verbundschicht (11) erhöht ist.

2. Halbleiterbauteil nach einem der vorhergehenden Ansprüche, wobei eine letzte Schicht (12), die das erste Material umfasst, auf der Oberfläche der Verbundschicht abgeschieden ist.

3. Halbleiterbauteil nach einem der vorhergehenden Ansprüche, wobei das erste Material Silicium ist.

4. Halbleiterbauteil nach einem der vorhergehenden Ansprüche, wobei das zweite Material Germanium ist.

5. Halbleiterbauteil nach einem der vorhergehenden Ansprüche, wobei die Zusammensetzung der Verbundschicht an ihrer Oberseite 10 bis 50 % des zweiten Materials umfasst.

6. Halbleiterbauteil nach Anspruch 5, wobei die Zusammensetzung der Verbundschicht an ihrer Oberseite 20 % des zweiten Materials umfasst.

7. Verfahren zur Herstellung eines Halbleiterbauelement, wobei das Verfahren Bereitstellen eines Substrats eines ersten Halbleitermaterials, Abscheiden einer Verbundschicht des ersten Halbleitermaterials und eines zweiten Halbleitermaterials auf dem Substrat umfasst, so dass das Verhältnis des ersten Materials zu dem zweiten Material der Verbundschicht weg von dem Substrat in Richtung der Oberseite der Verbundschicht abnimmt, **dadurch gekennzeichnet, dass** eine lineare Abnahme des Verhältnisses auf jeder Seite eines einzelnen Zwischenpunkts vorliegt, und dass die Abnahmerate des Verhältnisses auf jeder Seite des Zwischenpunkts unterschiedlich ist, wobei die Abnahmerate des Verhältnisses von dem Substrat weg in Richtung der Oberfläche der Verbundschicht erhöht ist.

8. Verfahren nach Anspruch 7, wobei das Verhältnis des ersten Materials zu dem zweiten Material der Verbundschicht teilweise herabgesetzt wird, indem die Temperatur, bei der die Schicht abgeschieden wird, von dem Substrat in Richtung der Oberfläche der Verbundschicht herabgesetzt wird.

## Revendications

1. Dispositif à semi-conducteur comprenant un substrat (10) constitué d'un premier matériau semi-conducteur et une couche composée (11) constituée dudit premier matériau semi-conducteur et d'un second matériau semi-conducteur disposée sur le substrat, le rapport du premier matériau au second matériau de la couche composée (11) étant amené à diminuer quand on s'éloigne du substrat vers la surface supérieure de la couche composée, **caractérisé en ce qu'**il y a une diminution linéaire du rapport d'un côté ou de l'autre d'un unique point intermédiaire et la vitesse de diminution du rapport est différente d'un côté ou de l'autre du point intermédiaire, la vitesse de diminution du rapport étant plus élevée quand on s'éloigne du substrat (10) vers la surface de la couche composée (11).

2. Dispositif à semi-conducteur tel que revendiqué dans une quelconque revendication précédente, dans lequel une couche finale (12) comprenant ledit premier matériau est déposée sur la surface de la couche composée.

3. Dispositif à semi-conducteur tel que revendiqué dans une quelconque revendication précédente, dans lequel le premier matériau est le silicium.

4. Dispositif à semi-conducteur tel que revendiqué dans une quelconque revendication précédente, dans lequel le second matériau est le germanium.

5. Dispositif à semi-conducteur tel que revendiqué dans une quelconque revendication précédente, dans lequel la composition de la couche composée au niveau de la surface supérieure de celle-ci comprend 10-50 % dudit second matériau.

6. Dispositif à semi-conducteur tel que revendiqué dans la revendication 5, dans lequel la composition de la couche composée au niveau de la surface supérieure de celle-ci comprend 20 % dudit second matériau.

7. Procédé de fabrication d'un dispositif à semi-conducteur, le procédé comprenant l'utilisation d'un substrat constitué d'un premier matériau semi-conducteur, le dépôt d'une couche composée constituée dudit premier matériau semi-conducteur et d'un second matériau semi-conducteur sur le substrat de façon telle que le rapport du premier matériau au second matériau de la couche composée diminue quand on s'éloigne du substrat vers la surface supérieure de la couche composée, **caractérisé en ce qu'**il y a une diminution linéaire du rapport d'un côté ou de l'autre d'un unique point intermédiaire et la vitesse de diminution du rapport est différente d'un côté ou de l'autre du point intermédiaire, la vitesse de diminution du rapport étant amenée à être plus élevée quand on s'éloigne du substrat vers la surface de la couche composée.

8. Procédé tel que revendiqué dans la revendication 7, dans lequel le rapport du premier matériau au second matériau de la couche composée est amené à diminuer en partie par diminution de la température à laquelle la couche est déposée du substrat vers la surface de la couche composée.
